# DEMANDE DE BREVET EUROPEEN

(11) **EP 1 262 997 A1**
(43) Date de publication de la demande: **04.12.2002**
(21) Numéro de dépôt: 02290765.3
(22) Date de dépôt: 27.03.2002
(51) Int. Cl.: G11C 16/04

(54) **Procédé d'effacement d'une cellule-mémoire de type FAMOS, et cellule-mémoire correspondante**

(30) Priorité: 05.04.2001 FR 0104621
(71) Demandeur: STMicroelectronics S.A., 92120 Montrouge (FR)
(72) Inventeur: Fournel, Richard, 38660 Lumbin (FR); Dray, Cirille, 38100 Grenoble (FR); Caspar, Daniel, 38660 Saint Hilaire du Touvet (FR)
(74) Mandataire: Casalonga, Axel

(57) **Abrégé**

On efface la cellule-mémoire électriquement, par exemple en appliquant une tension VB sur le substrat ayant une valeur supérieure d'au moins 4 volts à la plus faible des valeurs de tension appliquées sur la source VS et sur le drain VD, et inférieure à une tension limite prédéterminée de destruction de la cellule.

## Description

L'invention concerne les circuits intégrés, et plus particulièrement les cellules-mémoire ou points-mémoire de type FAMOS, c'est-à-dire basés sur un transistor de type FAMOS.

On rappelle que la technologie FAMOS, acronyme anglais de "Floating gate Avalanche injection MOS", utilise le point-mémoire obtenu avec un transistor MOS de type P dont l'unique grille est isolée (c'est-à-dire non connectée électriquement).

Cette grille unique est donc flottante.

Ce point-mémoire peut être obtenu sans ajouter d'étapes supplémentaires au procédé technologique de base de fabrication d'un transistor MOS de type P. Contrairement aux autres points-mémoire, par exemple de type FLASH, EPROM ou EEPROM, qui comprennent une grille flottante et une grille de commande, la cellule-mémoire de type FAMOS ne comprend qu'une seule grille flottante.

Actuellement, il n'est pas possible d'effacer électriquement ce point-mémoire de typeFAMOS et il faut recourir aux rayons ultraviolets. Ce type de point-mémoire est donc actuellement plus particulièrement utilisé comme mémoire programmable une seule fois, dite "mémoire OTP".

L'invention vise à s'affranchir d'un effacement par rayons UV de façon à pouvoir programmer et effacer plusieurs fois et à volonté une cellule-mémoire de type FAMOS, c'est à dire une cellule-mémoire comportant un transistor PMOS à grille unique flottante, intégrée au sein d'un circuit intégré.

Pour atteindre cet objectif, l'invention propose un effacement électrique d'une cellule-mémoire de type FAMOS,.

L'invention va donc à l'opposé des préjugés techniques dans le domaine et permet ainsi d'utiliser une cellule-mémoire de type FAMOS comme cellule de mémoire non volatile de type EEPROM ou FLASH.

Selon un mode de mise en oeuvre de l'invention, on peut effacer la cellule-mémoire quelles que soient les valeurs des tensions sur la source et sur le drain du transistor PMOS , pour autant qu'on applique une tension sur le substrat ayant une valeur supérieure d'au moins 4 volts à la plus faible des valeurs de tension appliquées sur la source et sur le drain. Toutefois, cette tension de substrat doit rester inférieure à une tension limite prédéterminée de destruction de la cellule.

A titre indicatif, la tension limite prédéterminée est la tension de claquage des diodes substrat/source et substrat/drain.

Bien entendu, cette tension limite prédéterminée de destruction est fonction de la technologie utilisée. Actuellement, on fixe cette tension limite prédéterminée à environ 10 volts.

De façon à réduire le temps d'effacement de la cellule-mémoire, on peut appliquer avantageusement une tension sur le substrat dont la valeur est supérieure d'au moins 6 volts à la plus faible des valeurs de tension appliquées sur la source et sur le drain.

A titre indicatif, pour obtenir des temps d'effacement de l'ordre de la minute, on pourra par exemple appliquer des tensions de substrat de l'ordre de 7 à 8 volts.

On peut appliquer la même tension sur la source et sur le drain. Toutefois, une autre possibilité pour réduire le temps d'effacement consiste à appliquer une différence de tension non nulle et positive entre la source et le drain.

Ceci étant, dans certaines applications, il est préférable que la valeur de cette différence entre la tension de source et la tension de drain reste inférieure à une valeur de seuil prédéterminée, afin de ne pas positionner la cellule-mémoire à un état électrique intermédiaire.

Ainsi, à titre indicatif, on pourra avantageusement utiliser une valeur de seuil prédéterminée inférieure à 2 volts, par exemple de l'ordre de 1 volt.

En variante, il serait également possible d'appliquer une différence de tension variable entre la source et le drain. Ainsi, par exemple, on pourrait appliquer au début de la phase d'effacement, une différence de tension positive entre la source et le drain, et ce de façon à déclencher plus rapidement l'effacement, puis on appliquerait une différence de tension nulle entre la source et le drain de façon à éviter d'atteindre un état électrique intermédiaire de la cellule-mémoire.

L'effacement électrique de la cellule-mémoire selon l'invention est réalisable quelle que soit la configuration du transistor PMOS de la cellule-mémoire. On peut ainsi prévoir un transistor PMOS ayant une configuration classique linéaire ou bien une configuration annulaire comprenant une électrode au centre, entourée de la grille, et une électrode périphérique.

Une telle configuration annulaire permet, pour certains types de process, de rendre l'effacement plus efficace en réduisant le temps nécessaire pour l'effacement par rapport à une configuration linéaire.

L'invention a également pour objet un dispositif de mémoire, comprenant une cellule-mémoire de type FAMOS. Selon une caractéristique générale de l'invention, la cellule-mémoire est électriquement effaçable.

Selon un mode de réalisation de l'invention, la cellule comporte un transistor PMOS réalisé dans un substrat semiconducteur et le dispositif comporte des moyens d'effacement aptes à appliquer une tension sur le substrat ayant une valeur supérieure d'au moins 4 volts à la plus faible des valeurs de tension appliquées sur la source et sur le drain, et inférieure à une tension de limite prédéterminée de destruction de la cellule.

Selon un mode de réalisation préférentiel de l'invention, les moyens d'effacement sont aptes à appliquer une tension sur le substrat dont la valeur est supérieure d'au moins 6 volts à la plus faible des valeurs de tension appliquées sur la source et sur le drain.

De façon à réduire le temps d'effacement, les moyens d'effacement sont avantageusement aptes à appliquer une différence de tension non nulle et positive entre la source et le drain, tout en restant de préférence inférieure à une valeur de seuil prédéterminée, par exemple de l'ordre de 1 volt.

Le dispositif de mémoire selon l'invention comporte également des moyens de programmation aptes à écrire une donnée dans la cellule-mémoire, des moyens de lecture aptes à lire le contenu de la cellule-mémoire, et des moyens de commande aptes à connecter sélectivement les moyens de programmation, de lecture et d'effacement à la cellule-mémoire, en fonction du mode de fonctionnement utilisé.

Le dispositif peut comporter plusieurs cellules-mémoire du type FAMOS électriquement effaçables, par exemple un plan-mémoire formé d'une matrice de cellules-mémoire organisées en lignes et en colonnes.

L'invention a également pour objet un circuit intégré comprenant un dispositif de mémoire tel que défini ci-avant.

D'autres avantages et caractéristiques de l'invention apparaîtront à l'examen de la description détaillée de modes de réalisation et de mise en oeuvre, nullement limitatifs, et des dessins annexés, sur lesquels :
- la figure 1 illustre schématiquement un premier mode de réalisation d'une cellule-mémoire de type FAMOS selon l'invention;
- la figure 2 illustre toujours schématiquement une mise en oeuvre d'un effacement d'une cellule-mémoire selon l'invention;
- la figure 3 illustre schématiquement une mise en oeuvre d'une programmation et d'une lecture d'une cellule-mémoire selon l'invention;
- la figure 4 illustre schématiquement un mode de réalisation d'un circuit intégré incorporant une cellule-mémoire selon l'invention ainsi que les différents moyens d'effacement de programmation et de lecture de cette cellule-mémoire; et
- les figures 5 et 6 illustrent deux variantes de configuration du transistor PMOS d'une cellule-mémoire selon l'invention.

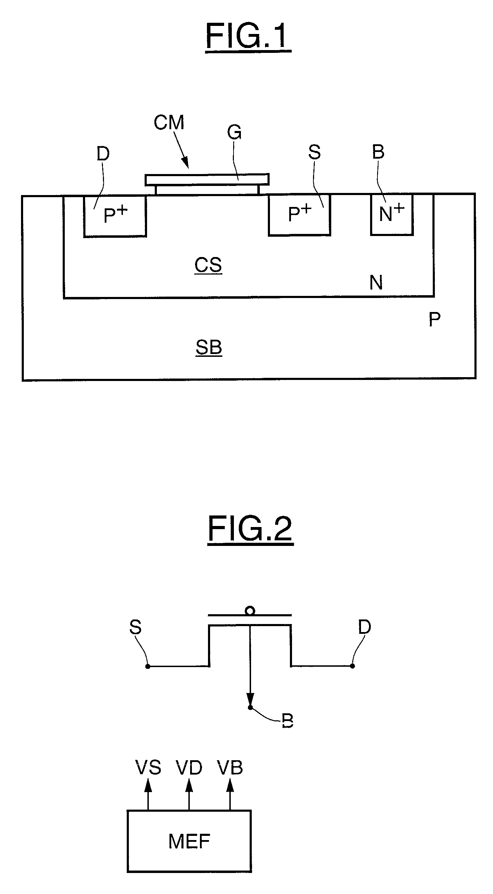

Sur la figure 1, la réfence CM désigne une cellule-mémoire ou point-mémoire de type FAMOS selon l'invention. Sur cette figure, cette cellule-mémoire comporte un transistor MOS de type P comportant une grille G, une région de drain D dopée P⁺, une région de source S également dopée P⁺. Dans l'exemple décrit, le transistor MOS est réalisé dans un caisson CS de type N, au sein d'un substrat SB de type P. Le transistor de la cellule-mémoire CM comporte par ailleurs une prise de substrat B (Bulk en langue anglaise) dopée N⁺, qui est ici une prise de caisson.

Une différence entre un point-mémoire FAMOS et un transistor MOS de type P classique, est que l'unique grille du transistor MOS est dans la cellule CM non connectée électriquement. En d'autres termes, cette grille G est flottante. D'autre part, l'épaisseur d'oxyde de grille et les implantations peuvent être ajustées pour optimiser les performances de la cellule.

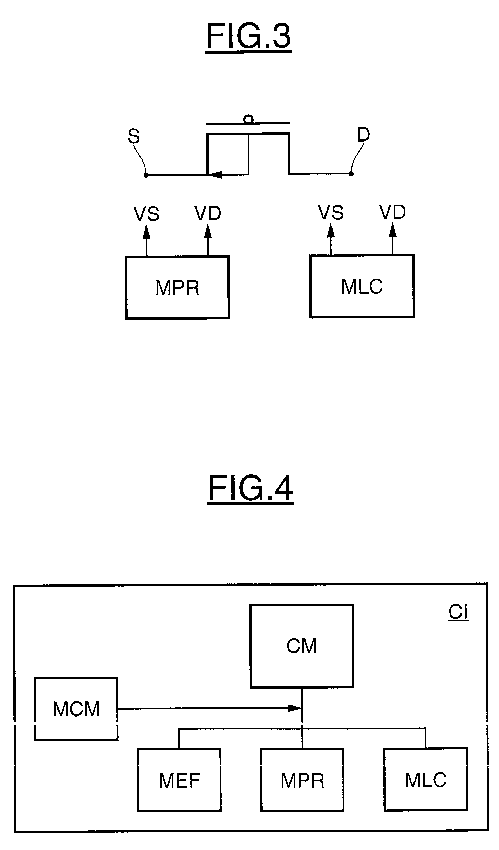

La programmation ainsi que la lecture du contenu de cette cellule-mémoire sont classiques et connues de l'homme du métier. On en rappelle ici brièvement le principe en se référant plus particulièrement à la figure 3.

Sur cette figure, on voit qu'il est classique pour la programmation et la lecture d'une cellule-mémoire, de connecter la source et la prise de caisson de façon à supprimer l'effet substrat.

La programmation du point-mémoire est obtenue par électrons chauds. Plus précisément, des moyens de programmation MPR, comportant notamment une source de tension, appliquent une tension de programmation VS sur la source S et appliquent une tension VD sur le drain, par exemple la masse. A titre indicatif, la tension de programmation appliquée sur la source est par exemple égale à 5 volts. Le potentiel de la grille monte par couplage capacitif avec la source et la prise de caisson. Il y a alors création d'électrons chauds au niveau du drain et injection dans la grille.

Lorsque la cellule est programmée, le transistor FAMOS est appauvri (déplété) et le courant source-drain est de l'ordre de 50 à 250 µA.

Par contre, lorsqu'une cellule FAMOS est vierge, c'est-à-dire non programmée, le courant source/drain est de l'ordre de quelques nA.

Pour la lecture, des moyens de lecture MLC délivrent la tension d'alimentation VS sur la source (par exemple 3,3 volts) et une tension VD sur le drain ,par exemple égale à 2,3 volts, telle que VS-VD soit inférieure ou égale à 1 volt.

Selon l'invention, l'effacement d'une cellule-mémoire FAMOS est réalisé de façon électrique. Plus précisément, comme illustré plus particulièrement sur la figure 2, il est prévu des moyens d'effacement MEF, comportant également une ou plusieurs sources de tension, et aptes à appliquer des tensions choisies sur respectivement la source, le drain et la prise de caisson. A cet égard, en mode d'effacement, la prise de caisson n'est plus connectée à la source de la cellule-mémoire. En pratique, il est prévu par exemple un commutateur permettant en fonction du mode de fonctionnement utilisé (programmation ou effacement) de connecter ou non ensemble la source et la prise de caisson.

Les moyens d'effacement MEF vont appliquer une tension sur la source VS et une tension sur le drain VD. L'effacement électrique de la cellule est obtenu quelles que soient les valeurs de VS et VD, pour autant que par ailleurs, les moyens MEF appliquent une tension VB sur le substrat (prise de caisson B) ayant une valeur supérieure d'au moins 4 volts à la plus faible des valeurs de tension appliquées sur la source et sur le drain.

Ainsi, à titre d'exemple, si les tensions VS et VD sont nulles, la tension VB sera choisie au moins égale à 4 volts. Ceci étant, il serait également envisageable d'appliquer des tensions négatives sur la source et/ou le drain. Mais dans ce cas, la tension VB resterait choisie de façon à être toujours supérieure à la plus faible des valeurs de tension appliquées sur la source et sur le drain.

La tension VB à appliquer sur la prise de caisson B doit rester toutefois inférieure à une valeur limite de destruction de la cellule-mémoire. Plus précisément, ici, la destruction est synonyme de claquage de la diode caisson/source et/ou caisson/drain.

Dans les technologies actuellement utilisées, cette tension de claquage est de l'ordre de 10 volts et, par conséquent, on ne dépassera guère 9 volts pour la tension VB.

La valeur de la tension VB joue également sur le temps d'effacement de la cellule-mémoire. Ainsi, plus cette tension est élevée, plus le temps d'effacement est court. A titre indicatif, dans les technologies utilisées, on obtiendra des temps d'effacement de l'ordre de la minute pour des tensions VB de l'ordre de 7 à 8 volts.

Un autre paramètre qui agit sur la durée du temps d'effacement est justement la valeur de la différence entre la tension VS et la tension VD. Plus cette valeur est grande, plus le temps d'effacement est court.

Ceci étant, l'application d'une différence de tension source/drain supérieure à une valeur de seuil prédéterminée, peut conduire à positionner la cellule à un état électrique intermédiaire quel que soit son état initial avant l'effacement (conduisant par exemple à un courant source/drain de l'ordre de quelques µA contre quelques nA pour une cellule vierge).

C'est la raison pour laquelle il est préférable dans certaines applications, de limiter la valeur de la différence de tension VS-VD, par exemple à 1 volt environ.

A titre indicatif, pour une technologie 0,18 µm, une application d'une tension de source VS de l'ordre de 1 volt, d'une tension de drain nulle et d'une tension de substrat VB de l'ordre de 7 à 8 volts, conduit à un effacement électrique de la cellule-mémoire au bout d'une durée d'environ 1 minute.

Bien entendu, lorsque la cellule-mémoire CM est intégrée au sein d'un circuit intégré CI (figure 4), le dispositif de contrôle entourant cette cellule-mémoire comporte les moyens d'effacement MEF, les moyens de programmation MPR, les moyens de lecture MLC et également des moyens de commande MCM, comportant par exemple une logique de commutation, capable de connecter sélectivement chacun de ces moyens à la cellule-mémoire en fonction du mode de fonctionnement utilisé.

L'effacement d'une cellule-mémoire de type FAMOS est possible électriquement quelle que soit la configuration du transistor PMOS qui la compose.

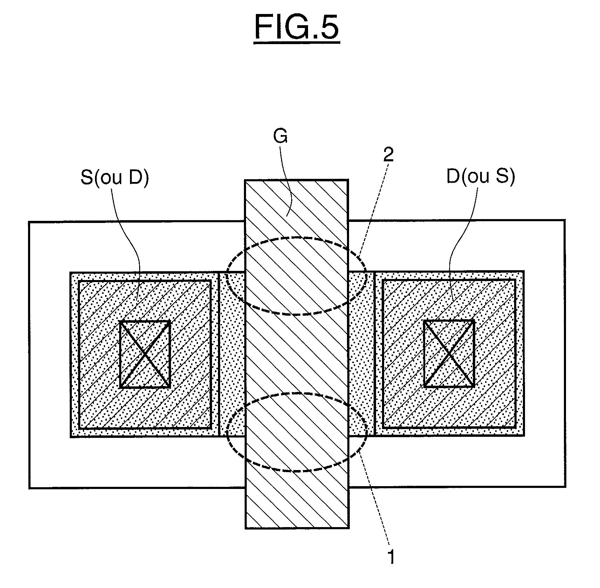

Ainsi, on peut utiliser une configuration linéaire, correspondant au mode de réalisation de la figure 1 et illustrée schématiquement sur la figure 5. Sur cette figure 5, les zones de diffusion de drain D et de source S sont réalisées dans des caissons N et alignées par rapport à la grille G en polysilicium dans la direction transversale. De façon classique, on isole les différents éléments actifs du substrat par de l'oxyde de champ. Le point-mémoire est ainsi isolé des autres éléments actifs du circuit intégré par de l'oxyde de champ, sur tout le tour du transistor délimité par le caisson. Différentes techniques peuvent être employées pour réaliser cet oxyde de champ, comme une technique dite "d'oxydation localisée" (LOCOS) ou bien une technique de tranchées peu profondes (STI : Shalow Trench Insolation), qui permet d'avoir une épaisseur d'oxyde en surface plus fine.

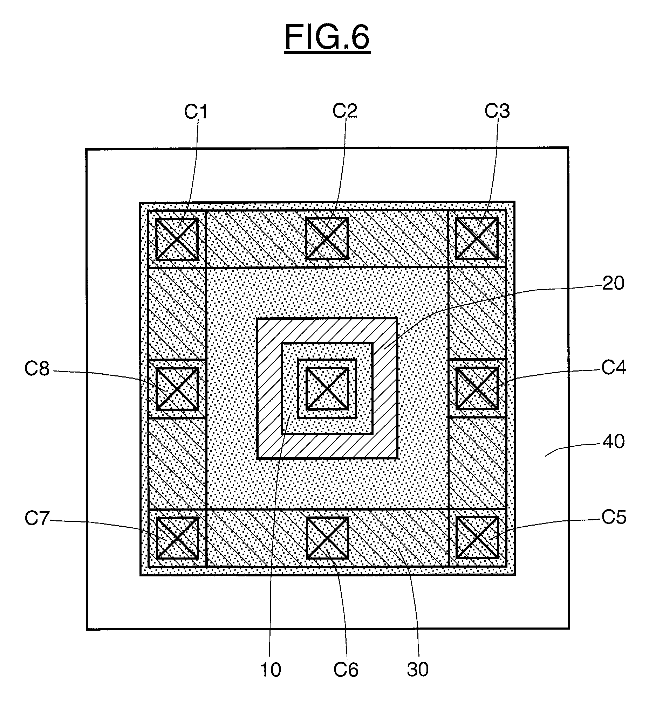

Ceci étant, il est particulièrement avantageux d'utiliser une configuration annulaire du transistor PMOS, telle que celle illustrée schématiquement sur la figure 6.

Dans cette configuration, on réalise une zone de diffusion centrale 10 et une zone de diffusion périphérique 30. La grille 20 en polysilicium se trouve dans le volume délimité par les deux diffusions. L'oxyde de champ 40 entoure la zone de diffusion périphérique.

Une telle réalisation annulaire ne nécessite aucune étape supplémentaire de fabrication, la différence entre la configuration droite (linéaire) et la configuration annulaire tenant simplement dans le dessin des différents éléments.

Dans la configuration annulaire, il est en outre préférable en pratique de réaliser plusieurs points de contact C1-C8 sur la zone de diffusion périphérique, pour diminuer la résistance d'accès de cette zone de diffusion périphérique 30.

La configuration annulaire permet d'obtenir de meilleures performances du point-mémoire selon l'invention, aussi bien en ce qui concerne la rétention des données qu'en ce qui concerne le temps d'effacement. En effet, les interfaces 1 et 2 de l'oxyde de champ avec la grille G dans une configuration linéaire (figure 5) sont des zones de fragilité de la structure dues aux différences de hauteur entre les éléments. Ceci va influer sur le temps de rétention des données et sur la durée d'effacement.

Avec la configuration annulaire, la grille 20 flottante (non connectée) est confinée dans un volume à l'intérieur de la zone de diffusion périphérique. Ainsi, la grille étant confinée à l'intérieur de la structure même du point-mémoire FAMOS, il n'y a plus aucune interface entre la grille et l'oxyde de champ.

En outre, en prenant comme source S l'électrode périphérique 30 et comme drain D l'électrode centrale 10, on favorise alors le couplage capacitif grille-source au détriment du couplage capacitif grille-drain, ce qui permet d'obtenir un potentiel de grille plus élevé dans la phase de programmation. Ainsi, la programmation est plus rapide et la quantité de charge injectée dans la grille plus importante. Par ailleurs, dans la phase d'effacement, la configuration annulaire permet de réduire le temps nécessaire à l'effacement.

L'invention n'est pas limitée aux modes de réalisation et de mise en oeuvre qui viennent d'être décrits mais en embrasse toutes les variantes.

Ainsi, tout ce qui vient d'être décrit s'applique également dans le cas où la cellule-mémoire CM est réalisée directement dans un substrat SB de type N, ou dans le cas d'un process SOI (Silicium sur Isolant).

En outre, l'invention s'applique également à une configuration annulaire dans laquelle l'électrode centrale est la source et l'électrode périphérique le drain.

Par ailleurs, le circuit intégré selon l'invention peut incorporer une ou plusieurs matrices de cellule-mémoire FAMOS selon l'invention, individuellement électriquement effaçables, de façon à constituer un ou plusieurs plans-mémoire adressables de façon classique par lignes et par colonnes et formant des mémoires non volatiles électriquement programmables et effaçables ( FLASH, EEPROM).

## Revendications

1. Procédé d'effacement d'une cellule-mémoire de type FAMOS, **caractérisé par le fait qu'**on efface ladite cellule-mémoire (CM) électriquement.

2. Procédé selon la revendication 1, **caractérisé par le fait que** la cellule (CM) comportant un transistor PMOS réalisé dans un substrat semiconducteur, on efface la cellule-mémoire en appliquant une tension sur le substrat ayant une valeur supérieure d'au moins 4 volts à la plus faible des valeurs de tension appliquées sur la source et sur le drain, et inférieure à une tension limite prédéterminée de destruction de la cellule.

3. Procédé selon la revendication 2, **caractérisé par le fait qu'**on applique une tension (VB) sur le substrat dont la valeur est supérieure d'au moins 6 volts à la plus faible des valeurs de tension appliquées sur la source et sur le drain.

4. Procédé selon la revendication 2 ou 3, **caractérisé par le fait que** la tension limite prédéterminée est de l'ordre de 10 volts.

5. Procédé selon l'une des revendications 2 à 4, **caractérisé par le fait qu'**on applique une différence de tension non nulle et positive entre la source et le drain.

6. Procédé selon la revendication 5, **caractérisé par le fait qu'**on applique une tension sur la source et une tension sur le drain telle que la valeur de la différence entre la tension de source et la tension de drain soit inférieure à une valeur de seuil prédéterminée.

7. Procédé selon la revendication 6, **caractérisé par le fait que** ladite valeur de seuil prédéterminée est de l'ordre de 1 volt.

8. Procédé selon l'une des revendications 2 à 4, **caractérisé par** le fait au'on applique une différence de tension variable entre la source et le drain pendant l'effacement.

9. Procédé selon l'une des revendications précédentes, **caractérisé par le fait que** le transistor PMOS de la cellule-mémoire a une configuration annulaire comprenant une électrode au centre(10), entourée de la grille (20), et une électrode périphérique(30).

10. Dispositif de mémoire, comprenant une cellule-mémoire de type FAMOS, **caractérisé par le fait que** la cellule-mémoire (CM) est électriquement effaçable.

11. Dispositif selon la revendication 10, **caractérisé par le fait que** la cellule comportant un transistor PMOS réalisé dans un substrat semiconducteur, **par le fait que** le dispositif comporte des moyens d'effacement (MEF) aptes à appliquer une tension sur le substrat supérieure d'au moins 4 volts à la plus faible des valeurs de tension appliquées sur la source et sur le drain, et inférieure à une tension limite prédéterminée de destruction de la cellule.

12. Dispositif selon la revendication 11, **caractérisé par le fait que** les moyens d'effacement (MEF) sont aptes à appliquer une tension sur le substrat dont la valeur est supérieure d'au moins 6 volts à la plus faible des valeurs de tension appliquées sur la source et sur le drain.

13. Dispositif selon la revendication 11 ou 12, **caractérisé par le fait que** la tension limite prédéterminée est de l'ordre de 10 volts.

14. Dispositif selon l'une des revendications 11 à 13, **caractérisé par le fait que** les moyens d'effacement sont aptes à appliquer une tension sur la source et une tension sur le drain telle que la valeur de la différence entre la tension de source et la tension de drain soit non nulle et positive.

15. Dispositif selon la revendication 14, **caractérisé par le fait que** les moyens d'effacement sont aptes à appliquer une tension sur la source et une tension sur le drain telle que la valeur de la différence entre la tension de source et la tension de drain soit inférieure à une valeur de seuil prédéterminée.

16. Dispositif selon la revendication 15, **caractérisé par le fait que** ladite valeur de seuil prédéterminée est de l'ordre de 1 volt.

17. Dispositif selon l'une des revendications 11 à 13, **caractérisé par le fait que** les moyens d'effacement sont aptes à appliquer une différence de tension variable entre la source et le drain pendant l'effacement.

18. Dispositif selon l'une des revendications 10 à 17, **caractérisé par le fait que** le transistor PMOS de la cellule-mémoire a une configuration annulaire comprenant une électrode au centre (10), entourée de la grille (20), et une électrode périphérique (30).

19. Dispositif selon l'une des revendications 10 à 18, **caractérisé par le fait qu'**il comporte des moyens de programmation aptes à écrire une donnée dans la cellule-mémoire, des moyens de lecture aptes à lire le contenu de la cellule-mémoire, et des moyens de commande aptes à connecter sélectivement les moyens de programmation, de lecture et d'effacement à la cellule-mémoire.

20. Dispositif selon l'une des revendications 10 à 19, **caractérisé par le fait qu'**il comporte plusieurs cellules-mémoire de type FAMOS électriquement effaçables.

21. Circuit intégré comprenant un dispositif de mémoire selon l'une des revendications 10 à 20.
